# EUROPÄISCHE PATENTANMELDUNG

(11) **EP 2 704 325 A1**
(43) Veröffentlichungstag der Anmeldung: **05.03.2014**
(21) Anmeldenummer: 12182162.3
(22) Anmeldetag: 29.08.2012
(51) Int. Cl.: H03K 17/12

(54) **Ausgabebaugruppe und Verfahren zum Betrieb**

(71) Anmelder: Siemens Aktiengesellschaft, 80333 München (DE)
(72) Erfinder: Haritounian, Sevan, 92224 Amberg (DE); Deml, Michael, 92436 Bruck (DE); Fichtlscherer, Martin, 92280 Kastl (DE); Kemptner, Sebastian, 92521 Schwarzenfeld (DE); Kiendl, Thomas, 92533 Wernberg-Köblitz (DE); König, Mathias, 91284 Neuhaus an der Pegnitz (DE); Mark, Reinhard, 91217 Hersbruck (DE); Vogel, René, 91217 Hersbruck (DE)

(57) **Zusammenfassung**

Die Erfindung betrifft ein Verfahren zum Betrieb einer Ausgabebaugruppe (1) mit einer Ausgangsschaltung (10) mit der an eine an einen Ausgang (2) angeschlossene Last (L) eine Spannung (U) angeschaltet wird, welche einen Strom (I) zur Folge hat, wobei zwischen einem Versorgungsspannungsanschluss (3) der Ausgabebaugruppe (1) und dem Ausgang (2) ein erstes Treibermodul (11) betrieben wird und zur Spannungsanschaltung an den Ausgang (2) über einen ersten Steuereingang (21) angesteuert wird, wobei zwischen dem Versorgungsspannungsanschluss (3) und dem Ausgang (2) ein zweites Treibermodul (12) parallel zu dem ersten Treibermodul (11) betrieben wird und auch zur Spannungsanschaltung an den Ausgang (2) über einen zweiten Steuereingang (22) angesteuert wird, wobei eine Steuerschaltung (30) einen Schaltbefehl (40) zum Schalten der Spannung (U) an den Ausgang (2) zu einem Startzeitpunkt (T0) erhält und die Steuerschaltung (30) in einem ersten Schritt mit einem wechselseitigen Ansteuern des ersten Steuereingangs (11) bzw. des zweiten Steuereingangs (12) startet, wobei das wechselseitige Ansteuern für die Dauer einer ersten Zeitdauer (T1) durchgeführt wird und das erste Treibermodul (11) während dieser wechselseitigen Ansteuerung jeweils für die Dauer einer ersten Ansteuerzeit (T11) den Strom (I) führt und das zweite Treibermodul (12) für die Dauer einer zweiten Ansteuerzeit (T12) den Strom (I) führt.

## Beschreibung

Die Erfindung betrifft ein Verfahren zum Betrieb einer Ausgabebaugruppe mit einer Ausgangsschaltung mit der an eine an einen Ausgang angeschlossene Last eine Spannung angeschaltet wird, wobei zwischen einem Versorgungsspannungsanschluss der Ausgabebaugruppe und dem Ausgang ein erstes Treibermodul betrieben wird und zur Spannungsanschaltung an den Ausgang über einen ersten Steuereingang angesteuert wird.

Für das Schalten, von beispielsweise kapazitiven Lasten, mit einer, vorzugsweise fehlersicheren, digitalen Ausgabebaugruppe einer speicherprogrammierbaren Steuerung, werden bereits heute elektronische Leistungsbauelemente zum Schalten der positiven Ausgangsspannung in einer Ausgabebaugruppe eingesetzt. Diese elektronischen Leistungsbauelemente sind vorzugsweise als Halbleiterschaltelemente ausgestaltet.

Insbesondere beim Einschalten von kapazitiven Lasten mit einem geringen Serienwiderstand tritt im ersten Augenblick ein hoher Einschaltstrom auf. Bei Leistungsbauelementen, die über eine Abschaltung des Stromes in einem Kurzschlussfall verfügen, kann dieser hohe Strom zu einem Ansprechen einer Überstromüberwachung oder Kurzschlussstromüberwachung und damit zu einer Abschaltung des Leistungsbauelementes führen, welches nicht gewünscht ist.

Die Offenlegungsschrift DE 10 2006 030 448 A1 offenbart eine Ausgangsschaltung für eine Ausgangsbaugruppe zum Schalten wenigstens einer angeschlossenen Last.

Da eine Baugröße von Ausgabebaugruppen, insbesondere in der Automatisierungstechnik, sich stetig verkleinert, wird nach einer Lösung gesucht um bei einem reduzierten Bauraum der Ausgabebaugruppe und einer zusätzlich erhöhten Packungsdichte von elektronischen Bauelemente auf einer Leiterplatte der Ausgabebaugruppe eine Erwärmung auf zulässige Werte zu begrenzen oder auch die Verlustleistung möglichst gering zu halten.

Es ist demnach Aufgabe der Erfindung eine Ausgabebaugruppe bereitzustellen, welche es ermöglicht, insbesondere beim Schalten von kapazitiven Lasten, den zu Anfang eines Schaltvorganges herrschenden hohen Einschaltstrom zu bewältigen und dennoch die Ausgabebaugruppe nicht zu sehr mit entstehender Verlustwärme zu belasten.

Bei einem Verfahren zum Betrieb einer Ausgabebaugruppe mit einer Ausgangsschaltung mit der an eine an einen Ausgang angeschlossenen Last eine Spannung angeschaltet wird, wobei zwischen einem Versorgungsspannungsanschluss der Ausgabebaugruppe und dem Ausgang ein erstes Treibermodul betrieben wird und zur Spannungsanschaltung an den Ausgang über einen ersten Steuereingang angesteuert wird, wird die Aufgabe dadurch gelöst, dass zwischen dem Versorgungsspannungsanschluss und dem Ausgang ein zweites Treibermodul parallel zu dem ersten Treibermodul betrieben wird und auch zur Spannungsanschaltung an den Ausgang über einen zweiten Steuereingang angesteuert wird, wobei eine Steuerschaltung einen Schaltbefehl zum Schalten der Spannung an den Ausgang zu einem Startzeitpunkt erhält und die Steuerschaltung in einem ersten Schritt mit einem wechselseitigen Ansteuern des ersten Steuereingangs bzw. des zweiten Steuereingangs startet, wobei das wechselseitige Ansteuern für die Dauer einer ersten Zeitdauer durchgeführt wird und das erste Treibermodul während dieser wechselseitigen Ansteuerung jeweils für die Dauer einer ersten Ansteuerzeit den Strom führt und das zweite Treibermodul jeweils für die Dauer einer zweiten Ansteuerzeit den Strom führt. Durch die beiden parallel geschalteten Treibermodule und durch die zeitliche abwechselnde Ansteuerung der Treibermodule kann eine mögliche schaltbare kapazitive Last bzw. der maximal zulässige Einschaltstrom erhöht werden. Während einer Übergangszeit von einem Einschaltaugenblick bis zu einer annähernd geladenen Kapazität ist immer nur eines der beiden Treibermodule aktiv. Das erste Treibermodul wird zunächst für die erste Ansteuerzeit eingeschaltet, wobei die Zeitdauer der ersten Ansteuerzeit nicht ausreicht um ein automatisches Abschalten aufgrund eines Überstromes in dem ersten Treibermodul auszulösen. Wird daraufhin das erste Treibermodul abgeschaltet bzw. nicht mehr angesteuert, wird quasi zeitgleich das zweite Treibermodul für eine zweite Ansteuerzeit eingeschaltet, welche ebenfalls nicht ausreicht, trotz des jetzt fließenden hohen Stromes, die Überstromüberwachung für eine Abschaltung auszulösen. Vorzugsweise ist stets eines der Treibermodule eingeschaltet und führt den Strom, wobei das jeweils andere Treibermodul ausgeschaltet ist. Dieses wechselseitige Hin- und Herschalten zwischen den beiden Treibermodulen hat zur Folge, dass eine kapazitive Last geladen werden kann. Eine entstehende Verlustleistung teilt sich somit auf zwei Bauteile gleichmäßig auf und verursacht eine geringere Temperaturerhöhung pro Treibermodul als bei der Verwendung von nur einem Treibermodul.

Für eine Abschaltung bei einem Überstrom wird das erste und das zweite Treibermodul mit je einer Stromabschaltvorrichtung betrieben, welche dafür ausgelegt sind, einen maximalen Strom nur eine bestimmte Zeitdauer einer Zulässigkeitszeitdauer zuzulassen und bei Überschreitung der Zulässigkeitszeitdauer den Strom abzuschalten.

Dabei wird die erste Ansteuerzeit und die zweite Ansteuerzeit jeweils kleiner als die einzelnen Zulässigkeitszeitdauern der jeweiligen Stromabschaltvorrichtungen gewählt.

Ist eine zu schaltende Kapazität annähernd geladen, werden in einen zweiten Schritt im Anschluss an das wechselseitige Ansteuern des ersten Treibermoduls und des zweiten Treibermoduls nach Ablauf der ersten Zeitdauer beide Treibermodule zeitgleich angesteuert.

Mit Beginn des zweiten Schrittes des Verfahrens ist der Strom mittlerweile soweit abgesunken, dass beide Treibermodule nun permanent eingeschaltet werden können, wobei dennoch eine Aufteilung auf zwei Treibermodule erfolgt, um die dauerhaft entstehende Verlustleistung in der Ausgabebaugruppe auch in dem Fall gering zu halten, wenn kein hoher Einschaltstrom mehr herrscht.

In einer Alternative zur konstanten Zeitdauer wird über ein Strommessmittel der Strom ermittelt und unabhängig von der ersten Zeitdauer in dem ersten Schritt das wechselseitige Ansteuern der Treibermodule solange betrieben, bis der ermittelte Strom einen vorbestimmten Wert unterschritten hat. Danach kann auf Dauerbetrieb beider Treibermodule direkt umgeschaltet werden.

Weiterhin ist es möglich, über ein Spannungsmessmittel eine Ausgangsspannung am Ausgang zu ermitteln und unabhängig von der ersten Zeitdauer in dem ersten Schritt das wechselseitige Ansteuern der Treibermodule solange zu betreiben, bis die ermittelte Spannung einen vorbestimmten Wert überschritten hat. Auch danach kann direkt auf Dauerbetrieb beider Treibermodule umgeschaltet werden.

Mit besonderem Vorteil wird dieses Verfahren bei Ausgabebaugruppen, welche als eine fehlersichere funktionale Sicherheit ausgelegte Automatisierungskomponente betrieben werden, genutzt.

Insbesondere bei fehlersicheren Anwendungen wird das Verfahren vorteilhafter Weise dadurch ergänzt, dass das zweite Treibermodul mit einem Drahtbruchprüfmittel betrieben wird und zyklisch für eine Drahtbruchprüfung einer zu der Last geführten Leitung aktiviert wird, wobei während dieser Prüf-Zeit das erste Treibermodul ausgeschaltet wird.

Die eingangs genannte Aufgabe wird ebenso durch eine Ausgabebaugruppe, umfassend eine Ausgangsschaltung, einen Ausgang, einen Versorgungsspannungsanschluss, ein erstes Treibermodul mit einem ersten Steuereingang, wobei das erste Treibermodul zur Anschaltung einer Spannung an den Ausgang ausgestaltet ist und zwischen dem Versorgungsspannungsanschluss und dem Ausgang angeordnet ist, dadurch gelöst, dass zwischen dem Versorgungsspannungsanschluss und dem Ausgang ein zweites Treibermodul mit einem zweiten Steuereingang parallel zu dem ersten Treibermodul angeordnet ist und auch zur Spannungsanschaltung an den Ausgang ausgestaltet ist, wobei eine Steuerschaltung einen Befehlseingang, einen ersten Befehlsausgang und einen zweiten Befehlsausgang aufweist und ausgestaltet ist um einen Schaltbefehl zum Schalten der Spannung an den Ausgang zu einem Startzeitpunkt über den Befehlseingang entgegenzunehmen und mit einem wechselseitigen Ansteuern des ersten Steuereingangs bzw. des zweiten Steuereingangs die Spannungsanschaltung an den Ausgang zu starten, weiterhin ausgestaltet, dass das wechselseitige Ansteuern für die Dauer einer ersten Zeitdauer durchgeführt wird und das erste Treibermodul für die Dauer einer ersten Ansteuerzeit den Strom führt und das zweite Treibermodul für die Dauer einer zweiten Ansteuerzeit den Strom führt.

Bei dieser Ausgestaltung sind beide Treibermodule vorzugsweise als Halbleiterbauelemente mit einem geringen Durchlasswiderstand ausgestaltet. Beispielsweise werden in einem voll durchgeschalteten Zustand eines Feldeffekttransistors relativ niederohmige Werte gemessen, dabei liegen die Werte unter wenigen Milliohm. Mit einem so geringen Durchlasswiderstand können minimale Schaltverluste erreicht werden und demnach auch eine dauerhafte Verlustleistung gering gehalten werden.

Setzt man nun aber Halbleiterschaltelemente mit einem derartig geringen Durchlasswiderstand ein, so ist es von Vorteil, dass das erste und das zweite Treibermodul mit je einer Stromabschaltvorrichtung ausgestaltet ist, welche dafür ausgelegt sind einen maximalen Strom nur eine bestimmte Dauer einer Zulässigkeitszeitdauer zuzulassen und bei Überschreitung der Zulässigkeitszeitdauer den Strom abzuschalten.

In einer vorteilhaften Ausgestaltung ist die Ausgabebaugruppe derart ausgestaltet, dass die Steuerschaltung weiterhin ausgestaltet ist im Anschluss an das wechselseitige Ansteuern des ersten Treibermoduls und des zweiten Treibermoduls nach Ablauf der ersten Zeitdauer beide Treibermodule zeitgleich anzusteuern. Eine entstehende Verlustleistung teilt sich somit auf zwei Treibermodule gleichmäßig auf und verursacht eine geringere Temperaturerhöhung pro Treibermodul als bei der Verwendung von nur einem Treibermodul.

Um bei unterschiedlichen maximalen Einschaltströmen flexibel reagieren zu können, ist es von Vorteil, wenn die Ausgabebaugruppe ein Strommessmittel aufweist, welches den Strom ermittelt, wobei die Steuerschaltung weiterhin dazu ausgestaltet ist unabhängig von der ersten Zeitdauer das wechselseitige Ansteuern der Treibermodule solange zu betreiben, bis der ermittelte Strom einen vorbestimmten Wert unterschritten hat.

Auch kann ein Spannungsmessmittel vorhanden sein, welches eine Spannung am Ausgang ermittelt, wobei die Steuerschaltung weiterhin dazu ausgestaltet ist unabhängig von der ersten Zeitdauer das wechselseitige Ansteuern der Treibermodule solange zu betreiben, bis die ermittelte Spannung einen vorbestimmten Wert überschritten hat.

Insbesondere im Bezug auf den Einsatz einer Ausgabebaugruppe für fehlersichere auf funktionale Sicherheit ausgelegte Automatisierungskomponenten weist das zweite Treibermodul ein Drahtbruchprüfmittel auf, welches für eine zyklische Drahtbruchprüfung einer zu der Last geführten Leitung ausgestaltet ist.

Die Zeichnung zeigt ein Ausführungsbeispiel, dabei zeigt
- FIG 1: eine Ausgabebaugruppe 1 mit einem ersten Treibermodul und einem zweiten Treibermodul,
- FIG 2: zeitliche Verläufe der Ansteuerung der Treibermodule, sowie eine Ausgangsspannung an dem Ausgang und
- FIG 3: ein Spannungs-Stromdiagramm bezogen auf die zu schaltende Last.

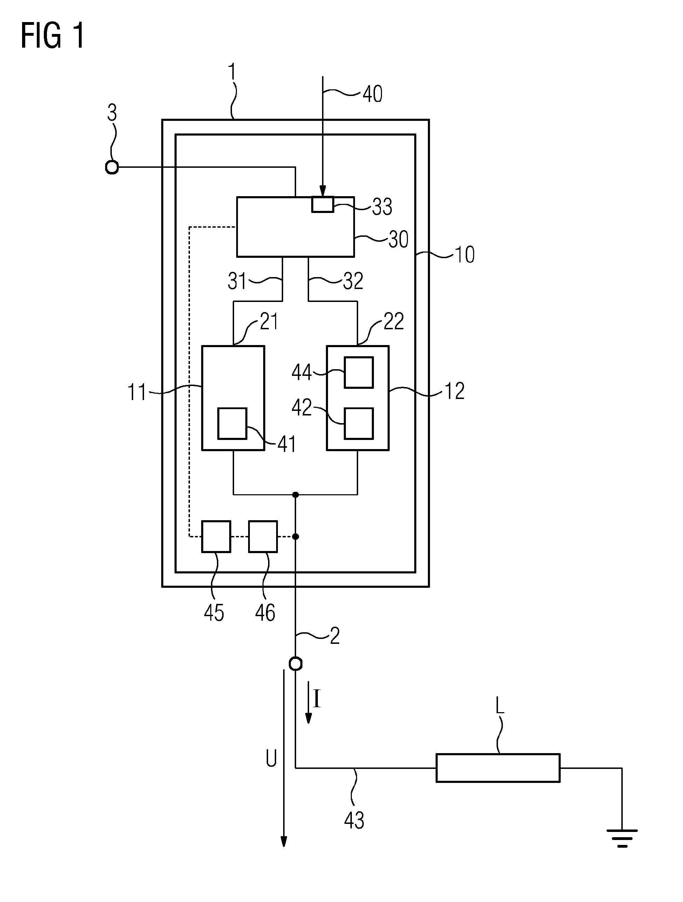

Gemäß FIG 1 ist eine Ausgabebaugruppe 1 umfassend eine Ausgangsschaltung 10, einen Ausgang 2, einen Versorgungsspannungsanschluss 3, ein erstes Treibermodul 11 mit einem ersten Steuereingang 21 und ein zweites Treibermodul 12 mit einem zweiten Steuereingang 22 gezeigt. Die Ausgabebaugruppe 1 ist mit ihrer Ausgangsschaltung 10 dazu ausgestaltet eine Spannung U über einen Ausgang 2 an eine Last L zu schalten.

Um eine entstehende Verlustleistung in der Ausgangsschaltung 10 in Grenzen zu halten, wird vorgeschlagen, zwei elektronische Halbleiterschaltelemente, nämlich das erste Treibermodul 11 und das zweite Treibermodul 12 derart einzusetzen, dass zwischen dem Versorgungsspannungsanschluss 3 und dem Ausgang 2 das erste Treibermodul 11 und das zweite Treibermodul 12 parallel zueinander angeordnet sind, wobei das erste Treibermodul 11 über einen ersten Steuereingang 21 und das zweite Treibermodul 12 über einen zweiten Steuereingang 22 wechselseitig angesteuert wird.

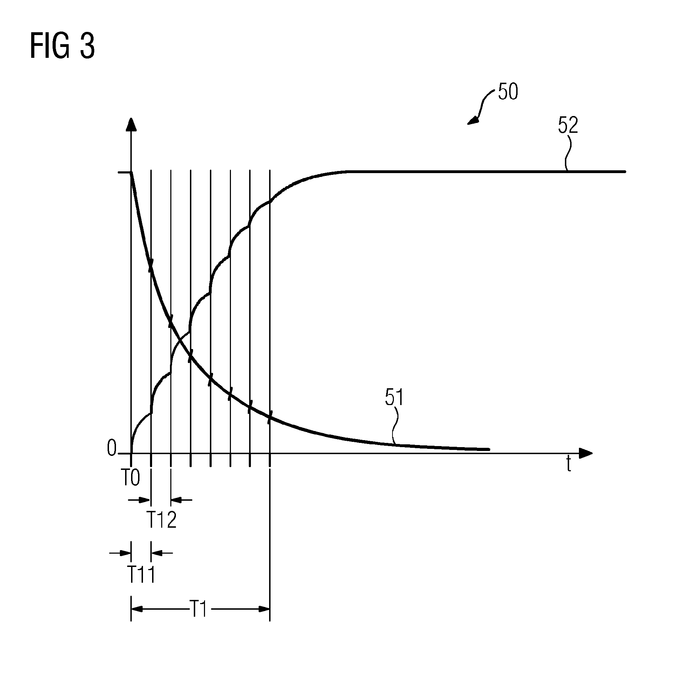

Demnach wird die Steuerschaltung 30 nach Erhalt eines Schaltbefehls 40 zum Schalten der Spannung U an den Ausgang zu einem Startzeitpunkt T0 derart tätig, dass in einem ersten Schritt das wechselseitige Ansteuern des ersten Steuereingangs 21 bzw. des zweiten Steuereingangs 22 gestartet wird, wobei das wechselseitige Ansteuern für die Dauer einer ersten Zeitdauer T1 durchgeführt wird (siehe FIG 3) und das erste Treibermodul 11 während dieser wechselseitigen Ansteuerung jeweils für die Dauer einer ersten Ansteuerzeit T11 den Strom I führt und das zweite Treibermodul 12 jeweils für die Dauer einer zweiten Ansteuerzeit T12 den Strom I führt. Das erste und das zweite Treibermodul 11,12 weisen je eine Stromabschaltvorrichtung 41,42 auf. Dabei sind diese erste Stromabschaltvorrichtung 41 und diese zweite Stromabschaltvorrichtung 42 dafür ausgelegt einen maximalen Strom nur eine bestimmte Dauer einer Zulässigkeitszeitdauer TZ zuzulassen und bei Überschreitung der Zulässigkeitszeitdauer TZ den Strom I abzuschalten.

Ist eine kapazitive Last im Bezug auf ihre Kapazität annähernd geladen kann ein in der Steuerschaltung 30 implementiertes Programm auf einen zweiten Schritt des Verfahrens übergehen. Dieser zweite Schritt wird im Anschluss an das wechselseitige Ansteuern des ersten Treibermoduls 11 und des zweiten Treibermoduls 12 nach Ablauf der ersten Zeitdauer T1 durchgeführt und steuert danach das erste Treibermodul 11 und das zweite Treibermodul 12 zeitgleich an.

Alternativ zu einer fest eingestellten Zeitdauer T1 weist die Ausgangsschaltung 10 ein Strommessmittel 45 auf, welches den Strom I ermittelt und unabhängig von der ersten Zeitdauer T1 in dem ersten Schritt das wechselseitige Ansteuern der Treibermodule 11,12 solange betrieben wird, bis der ermittelte Strom I einen vorbestimmten Wert unterschritten hat.

Auch ist es möglich über ein Spannungsmessmittel 46 die Ausgangsspannung 38 am Ausgang 2 zu ermitteln und unabhängig von der ersten Zeitdauer T1 in dem ersten Schritt das wechselseitige Ansteuern der Treibermodule 11,12 solange zu betreiben, bis der ermittelte Spannungswert einen vorbestimmten Wert überschritten hat.

Das zweite Treibermodul 12 weist ein Drahtbruchprüfmittel 44 auf, wobei dieses Drahtbruchprüfmittel 44 zyklisch betrieben wird und eine Drahtbruchprüfung einer zu der Last L geführten Leitung 43 durchführt, wobei während dieser Drahtbruch-Prüf-Zeit das erste Treibermodul 11 ausgeschaltet wird.

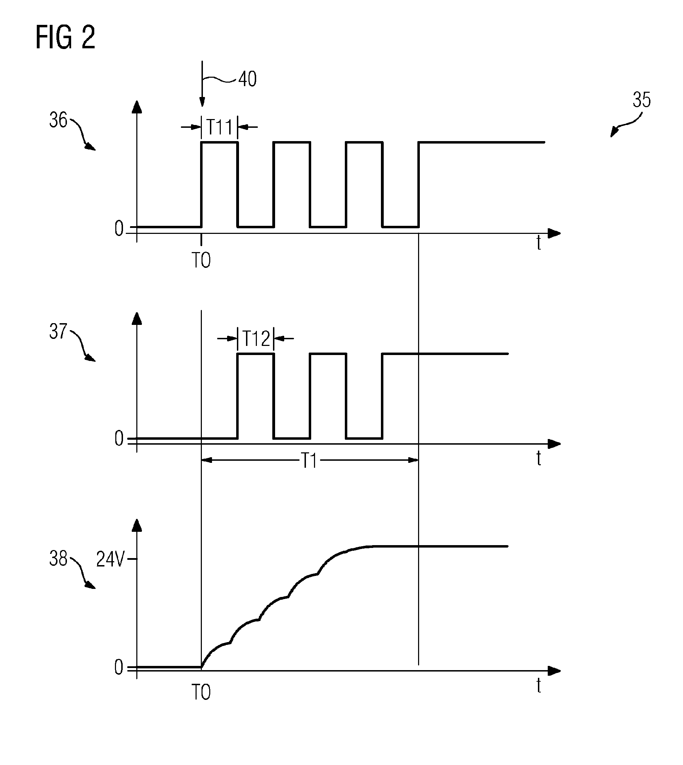

Mit der FIG 2 sind zeitliche Verläufe 35 der Ansteuerung der Treibermodule 11,12 und ein Spannungsverlauf 38 der Ausgangsspannung am Ausgang 2 dargestellt. Ein erstes Diagramm zeigt einen Signalverlauf 36 am ersten Steuereingang 21 des ersten Treibermoduls 11. Über die Zeit t ist ein logisches Schaltverhalten zwischen "0" und "1" dargestellt. Über die Steuerschaltung 30 wird zu einem Startzeitpunkt T0 der erste Steuereingang 21 mit logisch "1" angesteuert. Diese Ansteuerung wird für eine erste Ansteuerzeit T11 durchgeführt und nach Ablauf der ersten Ansteuerzeit T11 wird der erste Steuereingang 21 des ersten Treibermoduls 11 nicht mehr mit einer "1" angesteuert.

Quasi zeitgleich mit dem Abschalten des ersten Steuereingangs 21 wird der zweite Steuereingang 22 des zweiten Treibermoduls 12 für eine zweite Ansteuerzeit T12 mit einen zweiten Signalverlauf 38angesteuert. Nach Ablauf der zweiten Ansteuerzeit T12 wird wieder wechselseitig umgeschaltet auf den ersten Steuereingang 21, so dass das erste Treibermodul 11 den Strom I führt.

Mit Ablauf der Zeitdauer T1 wird davon ausgegangen, dass die Kapazität annähernd geladen ist und von nun an der fließende Strom I nicht mehr so hoch ist, dass er schädlich in Bezug auf eine entstehende Verlustleistung ist. Darum kann von nun an der erste Steuereingang 21 und der zweite Steuereingang 22 gleichzeitig angesteuert werden.

In einem weiteren Spannungsdiagramm der FIG 2 ist die Ausgangsspannung 38 am Ausgang 2 der Ausgabebaugruppe 1 dargestellt. Zu dem Startzeitpunkt T0, bei welchem das erste Treibermodul 11 aktiviert wird, steigt die Spannung allmählich an. Entsprechend den Ansteuerzeiten T11, T12 entstehen so Spannungsanstiegsstufen.

Die FIG 3 zeigt ein Spannungs-Stromdiagramm 50 mit welchem verdeutlicht werden soll, wie durch die wechselseitige Anschaltung der Spannung U der Strom I auf zwei unterschiedliche Treibermodule 11,12 aufgeteilt wird. Dabei zeigt eine Kurve den zeitlichen Verlauf 51 des Stromes I, wobei nach einem Startzeitpunkt T0 während der ersten Ansteuerzeit T11 der Strom I ziemlich rasch fällt. Für die Dauer der Ansteuerzeit T11 hat der Strom I das erste Treibermodul 11 belastet. Danach erfolgt ein wechselseitiges Umschalten auf das zweite Treibermodul 12 und für die Dauer der zweiten Ansteuerzeit T12 wird nun das zweite Treibermodul 12 mit dem Strom I belastet. Allmählich sinkt der Strom I und damit wird die Belastung der Treibermodule 11,12 auch geringer. Mit Ablauf der ersten Zeitdauer T1 kann eine Ansteuerung über die Steuereingänge 21,22 beider Treibermodule 11,12 zeitgleich erfolgen, denn nun ist der Strom I derart abgeklungen, dass er nicht mehr bildlich gesprochen, wie eine heiße Kartoffel von einer Hand in die andere Hand geworfen werden muss.

Die Kurve 52 zeigt den zeitlichen Verlauf der Spannung.

## Patentansprüche

1. Verfahren zum Betrieb einer Ausgabebaugruppe (1) mit einer Ausgangsschaltung (10) mit der an eine an einen Ausgang (2) angeschlossene Last (L) eine Spannung (U) angeschaltet wird, welche einen Strom (I) zur Folge hat, wobei zwischen einem Versorgungsspannungsanschluss (3) der Ausgabebaugruppe (1) und dem Ausgang (2) ein erstes Treibermodul (11) betrieben wird und zur Spannungsanschaltung an den Ausgang (2) über einen ersten Steuereingang (21) angesteuert wird,
**dadurch gekennzeichnet, dass** zwischen dem Versorgungsspannungsanschluss (3) und dem Ausgang (2) ein zweites Treibermodul (12) parallel zu dem ersten Treibermodul (11) betrieben wird und auch zur Spannungsanschaltung an den Ausgang (2) über einen zweiten Steuereingang (22) angesteuert wird, wobei eine Steuerschaltung (30) einen Schaltbefehl (40) zum Schalten der Spannung (U) an den Ausgang (2) zu einem Startzeitpunkt (T0) erhält und die Steuerschaltung (30) in einem
- ersten Schritt mit einem wechselseitigen Ansteuern des ersten Steuereingangs (11) bzw. des zweiten Steuereingangs (12) startet, wobei das wechselseitige Ansteuern für die Dauer einer ersten Zeitdauer (T1) durchgeführt wird und das erste Treibermodul (11) während dieser wechselseitigen Ansteuerung jeweils für die Dauer einer ersten Ansteuerzeit (T11) den Strom (I) führt und das zweite Treibermodul (12) für die Dauer einer zweiten Ansteuerzeit (T12) den Strom (I) führt.

2. Verfahren nach Anspruch 1,
wobei das erste und das zweite Treibermodul (11,12) mit je einer Stromabschaltvorrichtung (41,42) betrieben wird, welche dafür ausgelegt sind einen maximalen Strom (I) nur eine bestimmte Dauer einer Zulässigkeitszeitdauer (TZ) zulassen und bei Überschreitung der Zulässigkeitszeitdauer (TZ) den Strom (I) abzuschalten.

3. Verfahren nach Anspruch 2, wobei die erste Ansteuerzeit (T11) und die zweite Ansteuerzeit (T12) jeweils kleiner als die einzelne Zulässigkeitszeitdauer (TZ) der jeweiligen Stromabschaltvorrichtung (41,42) gewählt wird.

4. Verfahren nach einem der Ansprüche 1 bis 3, wobei in einem - zweiten Schritt im Anschluss an das wechselseitige Ansteuern des ersten Treibermoduls (11) und des zweiten Treibermoduls (12) nach Ablauf der ersten Zeitdauer (T1) beide Treibermodule (11,12) zeitgleich angesteuert werden.

5. Verfahren nach einem der Ansprüche 1 bis 4, wobei über ein Strommessmittel (45) der Strom (I) ermittelt wird und unabhängig von der ersten Zeitdauer (T1) in dem ersten Schritt das wechselseitige Ansteuern der Treibermodule (11,12) solange betrieben wird bis der ermittelte Strom (I) einen vorbestimmten Wert unterschritten hat.

6. Verfahren nach einem der Ansprüche 1 bis 5, wobei über ein Spannungsmessmittel (46) eine Ausgangsspannung (38) am Ausgang (2) ermittelt wird und unabhängig von der ersten Zeitdauer (T1) in dem ersten Schritt das wechselseitige Ansteuern der Treibermodule (11,12) solange betrieben wird bis die ermittelte Spannung einen vorbestimmten Wert überschritten hat.

7. Verfahren nach einem der Ansprüche 1 bis 6, wobei die Ausgabebaugruppe (1) als eine fehlersichere auf funktionale Sicherheit ausgelegte Automatisierungskomponente betrieben wird.

8. Verfahren nach einem der Ansprüche 1 bis 7, wobei das zweite Treibermodul (12) mit einem Drahtbruchprüfmittel (44) betrieben wird und zyklisch für eine Drahtbruchprüfung einer zu der Last (L) geführten Leitung (43) aktiviert wird, wobei während dieser Prüf-Zeit das erste Treibermodul (11) ausgeschaltet wird.

9. Ausgabebaugruppe (1), umfassend eine Ausgangsschaltung (10), einen Ausgang (2), einen Versorgungsspannungsanschluss (3), ein erstes Treibermodul (11) mit einem ersten Steuereingang (21), wobei das erste Treibermodul (11) zur Anschaltung einer Spannung (U) an den Ausgang (2) ausgestaltet ist und zwischen dem Versorgungsspannungsanschluss (3) und dem Ausgang (2) angeordnet ist,
**dadurch gekennzeichnet, dass** zwischen dem Versorgungsspannungsanschluss (3) und dem Ausgang (2) ein zweites Treibermodul (12) mit einem zweiten Steuereingang (21) parallel zu dem ersten Treibermodul (11) angeordnet ist und auch zur Spannungsanschaltung an den Ausgang (2) ausgestaltet ist, wobei eine Steuerschaltung (30) einen Befehlseingang (33), einen ersten Befehlsausgang (31) und einen zweiten Befehlsausgang (32) aufweist und ausgestaltet ist um einen Schaltbefehl (40) zum Schalten der Spannung (U) an den Ausgang (2) zu einem Startzeitpunkt (T0) über den Befehlseingang (33) entgegenzunehmen und
- mit einem wechselseitigen Ansteuern des ersten Steuereingangs (11) bzw. des zweiten Steuereingangs (12) die Spannungsanschaltung an den Ausgang (2) zu starten, weiterhin ausgestaltet ist, dass das wechselseitige Ansteuern für die Dauer einer ersten Zeitdauer (T1) durchgeführt wird und das erste Treibermodul (11) für die Dauer einer ersten Ansteuerzeit (T11) den Strom (I) führt und das zweite Treibermodul (12) für die Dauer einer zweiten Ansteuerzeit (T12) den Strom (I) führt.

10. Ausgabebaugruppe (1) nach Anspruch 9, wobei das erste und das zweite Treibermodul (11,12) mit je einer Stromabschaltvorrichtung (41,42) ausgestaltet ist, welche dafür ausgelegt sind einen maximalen Strom (I) nur eine bestimmte Dauer einer Zulässigkeitszeitdauer (TZ) zulassen und bei Überschreitung der Zulässigkeitszeitdauer (TZ) den Strom (I) abzuschalten.

11. Ausgabebaugruppe (1) nach Anspruch 9 oder 10, wobei die Steuerschaltung (30) weiterhin ausgestaltet ist im Anschluss an das wechselseitige Ansteuern des ersten Treibermoduls (11) und des zweiten Treibermoduls (12) nach Ablauf der ersten Zeitdauer (T1) beide Treibermodule (11,12) zeitgleich anzusteuern.

12. Ausgabebaugruppe (1) nach Anspruch 11, aufweisend ein Strommessmittel (45), welches den Strom (I) ermittelt, wobei die Steuerschaltung (30) weiterhin dazu ausgestaltet ist unabhängig von der ersten Zeitdauer (T1) das wechselseitige Ansteuern der Treibermodule (11,12) solange zu betrieben bis der ermittelte Strom (I) einen vorbestimmten Wert unterschritten hat.

13. Ausgabebaugruppe (1) nach Anspruch 11 oder 12, aufweisend ein Spannungsmessmittel (46), welches eine Spannung am Ausgang (2) ermittelt, wobei die Steuerschaltung (30) weiterhin dazu ausgestaltet ist unabhängig von der ersten Zeitdauer (T1) das wechselseitige Ansteuern der Treibermodule (11,12) solange zu betreiben bis die ermittelte Spannung einen vorbestimmten Wert überschritten hat.

14. Ausgabebaugruppe (1) nach einem der Ansprüche 9 bis 13, wobei das zweite Treibermodul (12) ein Drahtbruchprüfmittel (44) aufweist, welches für eine zyklische Drahtbruchprüfung einer zu der Last (L) geführten Leitung (43) ausgestaltet ist.
